# EUROPEAN PATENT SPECIFICATION

(11) **EP 3 572 559 B1**
(45) Date of publication and mention of the grant of the patent: **25.09.2024**
(21) Application number: 18785794.1
(22) Date of filing: 29.03.2018
(51) Int. Cl.: C30B 13/00, C30B 11/00, C30B 11/08

(54) **SINGLE CRYSTAL MANUFACTURING DEVICE**
EINKRISTALLHERSTELLUNGSVORRICHTUNG
DISPOSITIF DE FABRICATION D'UN MONOCRISTAL

(43) Date of publication of application: 27.11.2019
(73) Proprietor: Crystal Systems Corporation, Hokuto-shi, Yamanashi 408-0044 (JP)
(72) Inventor: SHINDO, Isamu, Hokuto-shi Yamanashi 4080041 (JP); HABU, Masayuki, Hokuto-shi Yamanashi 4080044 (JP)
(74) Representative: Michalski Hüttermann & Partner Patentanwälte mbB
(86) International application number: PCT/JP2018/013162
(87) International publication number: WO 2019/186870

(56) References cited:
- EP-A1- 1 930 483
- EP-A1- 3 299 498
- WO-A1-2018/003386
- JP-A- 2014 114 149
- JP-A- H06 100 394
- JP-A- H10 273 374
- JP-A- H10 273 374
- JP-A- H11 274 537
- JP-A- H11 292 682

## Description

### Technical Field

The present invention relates to: a single-crystal production equipment which highly efficiently produces a high-quality single crystal while homogenizing its composition to be optimum; (hereinafter, also referred to as "optimum crystal" using the single-crystal production equipment.

### Background Art

The term "single crystal" refers to a material in which atoms constituting its substance are orderly arranged throughout the material in accordance with a defined mode. Such single crystals prominently exhibit properties intrinsic to their substances with only minor disorder in atomic arrangement and are, therefore, utilized in a variety of fields such as semiconductor materials and optical materials.

In the industrial utilization of a single-crystal material, it is needless to say that the single-crystal material is required to have excellent properties; however, it is also an important element that the cost of producing and processing the single crystal should be low. Single crystals of, for example, silicon (Si) which is a principal semiconductor material, lutetium silicate (LSO; Lu₂SiO₅) which is a phosphor material, and yttrium aluminum garnet (YAG; Y₃Al₅O₁₂) which is a laser material, are all products produced by a "pulling method".

In the above-described single-crystal materials of Si, LSO, YAG and the like, a material doped with a useful dopant at a required concentration is used. For example, an Si single-crystal material is utilized as a phosphorus-doped N-type or boron-doped P-type semiconductor. Further, LSO and YAG are doped with cerium and neodymium, respectively.

In the production of these dopant-containing materials by the above-mentioned pulling method, a raw material is melted in an appropriate crucible and a seed single crystal is immersed in the resulting melt, after which the seed single crystal is pulled upward as it is grown in size, whereby a single crystal is produced.

This method belongs to so-called unidirectional solidification method where a melt is entirely solidified from an upper part in the downward direction; therefore, there is a drawback in that the dopant concentration in the resulting product is not constant due to a segregation phenomenon that occurs during the production of a single crystal as a solid from a melt.

In other words, a melt and a solidified single crystal do not have the same dopant concentration, and solidification proceeds at a ratio defined by the substance. This ratio is referred to as "distribution coefficient", and the concentration in the resulting crystal is, for example, approximately 0.35 when phosphorus is doped to silicon or approximately 0.2 when Ce is doped to LSO, taking the concentration in the melt as 1.

Accordingly, after the start of solidification from the dopant-containing melt, the dopant concentration in the generated single crystal is lower than that in the melt, and the difference remains in the melt. Thus, the dopant concentration in the melt gradually increases as the single crystal grows. Since the ratio between the dopant concentration in the melt and the dopant concentration in the generated single crystal is defined by a distribution coefficient, when the dopant concentration in the melt increases as crystallization proceeds, the dopant concentration in the single crystal being generated also gradually increases.

As other method of producing a single-crystal material, a floating-zone melting method is known. In this floating-zone melting method, generally, a lower end of a raw material rod molded in a round rod shape and the upper surface of a seed single crystal arranged below the raw material rod are melted and, with the resulting melts thereof being joined together and retained by surface tension between the raw material rod on the upper side and the seed single crystal on the lower side, the raw material is melted on the upper side of the thus joined melt while a single crystal is precipitated as a solid from the joined melt on the lower side thereof, whereby a single-crystal rod is produced.

As a means for melting the raw material, a high-frequency floating-zone melting method utilizing high-frequency induction (high-frequency FZ method) and an infrared floating-zone melting method of forming a melt by irradiation with an infrared ray (infrared FZ method) are known.

In the high-frequency FZ method and the infrared FZ method, since supply of a raw material to a melt and precipitation of a single crystal from the melt are continuously performed, the resulting single crystal and the raw material have the same dopant concentration in a steady state; therefore, these methods are single-crystal production methods capable of yielding a single-crystal product having a uniform composition. Further, since these methods do not use a crucible and are thus capable of producing a high-purity single crystal having no contamination with a crucible component, they are also single-crystal production methods that can be applied to materials for which an appropriate crucible material cannot be found.

However, the high-frequency FZ method has been indicated to have drawbacks in that it requires a dense high-quality raw material rod for continuously performing stable high-frequency induction, and that it is difficult to apply this method to insulator materials.

Meanwhile, the infrared FZ method is known to be advantageous in that it is applicable to a wide range of materials including insulator materials and good conductor materials, and that it does not necessarily require a highly dense raw material rod; however, this method can only produce small single crystal rods of approximately 20 to 30 mm in diameter at best, and such single crystal rods are mainly used as elements for research and development.

In a conventional infrared FZ method, an infrared ray is irradiated to a vertically arranged sample rod from the horizontal direction. The reason why this horizontal irradiation-type infrared FZ method (hereinafter, also referred to as "horizontal FZ method") cannot produce a large single crystal is because it is difficult to form a large melt required for the production of a large single crystal.

In other words, being capable of forming a melt by irradiating a material with an infrared ray means that the infrared ray is absorbed by the material and converted into heat. Since the infrared ray continues to be absorbed while passing through the melt, the amount of the infrared ray that can reach a deep part gradually decreases.

Accordingly, since the temperature of the melt decreases away from the surface, the interface between the growing single crystal and the melt as well as the interface between the raw material rod and the melt both tend to have a convex shape with respect to the melt.

In the vicinity of the center of the melt, therefore, the gap between the raw material rod on the upper side and a crystal rod on the lower side is narrower than in the periphery of the melt. When the raw material rod and the crystal rod come into contact with each other, since the shape of the melt is disturbed and the single-crystal production can no longer be continued due to dripping of the melt, it is desired to maintain the gap between the raw material rod and the crystal rod as wide as possible.

In this case, when it is tried to increase the dose of the infrared ray in the central part of the growing single crystal in order to prevent the raw material rod on the upper side and the crystal rod on the lower side from coming into contact with each other, the amount of the melt is increased in the outer part, making the melt likely to drip. Therefore, it is extremely difficult to produce such a large single crystal of greater than 30 mm in diameter as described above.

In view of the above, the present inventor developed an inclined irradiation-type infrared FZ method (hereinafter, also referred to as "inclined FZ method") in which an infrared ray is irradiated from obliquely above toward a lower part. In this inclined FZ method, a melt formed by melting a raw material naturally flows down to a lower part due to gravity and sits on a seed single crystal arranged below.

When the seed single crystal has a flat or concaved upper surface, the melt sitting thereon is maintained by surface tension. Therefore, in this inclined FZ method, theoretically, the melt can be stably retained on the seed single crystal even if the seed crystal has a large diameter, and this eliminates limitations on the diameter of a growable single crystal.

Accordingly, if melting of a raw material and solidification of a single crystal below the resulting melt could both be actually maintained in a stable state at the same time, it would be possible to produce a large single crystal (for example, Patent Literature 1) .

Until now, attempts have been made to produce a silicon single crystal by the inclined FZ method, and large single crystals of approximately 150 mm in diameter have already been produced.

This is a remarkable progress since the diameter of a silicon single crystal that could be produced by a conventional horizontal FZ method was thought to be approximately 30 mm.

Moreover, in the production of a silicon single crystal by a conventional pulling method, it is required to use a quartz crucible, and a large amount of this quartz component is incorporated into the resulting single crystal; therefore, due to an exsolution phenomenon attributed thereto, the product performance is largely deteriorated.

In the inclined FZ method, since such a defect is not introduced and a high-purity and high-quality single crystal having a uniform composition can be produced, there is a growing expectation for a further increase in the size of such a single crystal. However, the following problems have been revealed in the production of a larger single crystal by the inclined FZ method.

That is, in order to efficiently produce a large single crystal, it is important that a large raw material rod can be used. It is possible to produce a large single crystal using a small raw material rod; however, for example, in cases where a raw material rod having half the diameter of the crystal to be produced is used, it is necessary either to use a long raw material rod of four times the length of the crystal to be produced, or to prepare four raw material rods all having the same length as the crystal to be produced and to continuously perform the single-crystal production while replacing the four raw material rods one after another.

In this manner, in order to use a long raw material rod of four times the length of the product, the size of the single-crystal production equipment has to be increased and, for the use of raw material rods having the same length as that of the product, an equipment capable of replacing the raw material rods one after another in the middle of the production, or operations of replacing the raw material rods are required.

Moreover, when a large raw material rod is used for the production of a large single crystal, since the amount of energy required for melting the large raw material rod is extremely large, a large infrared generator and a large power supply equipment necessary for operating the infrared generator are required.

Usually, a raw material rod is melted by local heating of its lower part; however, for example, in order to melt a large raw material rod made of a material having a relatively high thermal conductivity such as silicon by local heating, since the heat is conducted to the entirety of the large raw material rod, a large amount of energy is required taking into account such heat conduction.

The inclined FZ method is a method of producing a single crystal by melting a raw material with irradiation of an infrared ray and subsequently solidifying the thus melted raw material, and the method generally uses a granular raw material molded into a rod shape; however, in this method, a granular raw material may be melted as is and then solidified as a single crystal.

This means that a method of solidifying a single crystal from a mixed melt formed by dropping a raw material melt, which is obtained by melting a granular raw material, onto a melt formed on the upper surface of a seed single crystal is feasible.

EP 3 299 498 and EP 1 930 483 both describe a growth equipment for the growth of a crystal on a seed where granular feedstock is fed on a seed and melted.

In view of this, the present inventor discovered, as an alternative to a system that uses a granular raw material molded into a rod shape as in a conventional method, a method of supplying a raw material melt, which is obtained by melting a granular raw material as is, into a melt formed on the upper surface of a seed single crystal and subsequently solidifying a single crystal from the resulting mixed melt.

By this, the energy required for melting a raw material is greatly reduced as compared to a system of using a large raw material rod and, even in the production of a long single-crystal product, a granular raw material can be supplied to a hopper storing the granular raw material in the midst of growing a single crystal; therefore, a long single crystal can now be produced extremely easily.

Meanwhile, among various materials, there are substances that are known to be difficult to process into a rod shape as a granular raw material or to stably melt as a rod-shaped raw material.

For example, in the production of a YBa₂Cu₃O₇ single crystal and a Bi₂Sr₂Ca₂Cu₃O₁₀ single crystal that are known as high-temperature superconducting substances, when a raw material rod obtained by molding powder (particles) of the respective composition is melted by irradiation with an infrared ray, since the raw material rod is partially melted and this makes the shape of the interface between the raw material rod and the resulting melt unstable, it is difficult to produce a high-quality single crystal.

In addition, for example, lithium niobate and lithium tantalate are known as substances for which preparation of a round rod-shaped raw material rod as well as production of a single crystal by the infrared FZ method using an ordinary round rod-shaped raw material rod are difficult.

By using a raw material melt generated by melting a granular raw material as is, the present inventor succeeded in greatly reducing the amount of the energy required for melting a raw material even in those cases where a large amount of energy is required for melting a large raw material rod as described above or those cases where preparation of a raw material rod or stable melting of a raw material rod is difficult.

Further, the present inventor discovered that, even in those cases where preparation of a raw material rod or stable melting of a raw material rod is difficult, the use of a raw material melt generated by melting a granular raw material as is enables to stably supply the raw material melt with a small amount of energy, so that a large high-quality single crystal can be produced.

### Citation List

### Patent Literature

Patent Literature 1: Japanese Patent No. 5279727

### Summary of Invention

### Technical Problem

Since the infrared FZ method is a method where a raw material is molded into a rod shape, melted by irradiation with an infrared ray and then solidified, it can be applied to a wide variety of materials ranging from good conductors to insulator materials, and the supply of the raw material into a melt and the solidification of the raw material from the melt are concurrently performed in this method; therefore, the infrared FZ method is a method to which a "traveling solvent method" essential for the production of a single crystal having a uniform composition is automatically applied, and the infrared FZ method is capable of yielding a single crystal having a uniform composition.

Moreover, the infrared FZ method does not use a crucible and is, therefore, a method capable of producing a high-purity single-crystal product with no contamination from a crucible.

However, it is difficult to apply the system of using a raw material molded into a rod shape to a substance for which preparation of a raw material rod is difficult or a substance for which a raw material rod can be prepared but stable formation of a melt is difficult.

In addition, the use of a large raw material rod for the production of a large single-crystal product requires an extremely large amount of energy for melting this large raw material rod.

Moreover, for the production of a long product, since it is necessary to perform operations of replacing a used raw material rod with a fresh raw material rod in the middle of the production, there are several disadvantages in terms of, for example, an increase in the equipment size, complexity of the operations, and an increase in the risk of introducing defects into the product at the time of performing the replacement operations.

All of these disadvantages are attributed to the system of using a raw material molded into a rod shape. Therefore, the development of a system that uses a raw material in a granular form as is without using a raw material rod has been desired.

### Solution to Problem

The above-described problems are all caused by the system of using a raw material molded into a rod shape. Accordingly, a system of using a granular raw material as is without molding it into a rod shape was examined, and it was consequently found that it is necessary to solve the following problems for the application of such a granular raw material to the infrared FZ method:
(1) to retain the granular raw material and to stably supply the granular raw material in a prescribed amount;
(2) to continuously melt the granular raw material and, at the same time, to separate molted raw material from unmelted raw material so as to supply only a complete raw material melt containing no unmelted raw material; and
(3) to stably form a melt on the upper surface of a seed single crystal by melting only the upper surface of the seed single crystal and to continuously perform the single-crystal production by adding dropwise the raw material melt onto the melt.

There are several systems for an equipment which retains a granular raw material in a hopper and supplies a certain amount of the granular raw material, and a number of such equipments are commercially available. However, for example, when a granular silicon is used for the production of a silicon single crystal, there are restrictions on the materials of usable parts for avoidance of contamination, and there is found no existing equipment that can be used stably over a long period.

In view of this, the present inventor invented a system in which a spiral rod coated with a material capable of inhibiting contamination is arranged and rotated in a hopper storing a granular raw material so as to avoid a situation where a cavity is created in the hopper and stable supply of the granular raw material is thereby hindered; an opening is formed on a lower part of the hopper and a spoon-like tool similarly made of a material capable of inhibiting contamination is inserted thereto to scrape out the granular raw material; the thus scraped granular raw material is supplied onto a granular raw material quantitative supply equipment below; and the granular raw material is then supplied downward in a prescribed amount. This system enables to stably supply a granular raw material over a long period.

In a method of producing a single crystal by melting and solidifying a granular raw material, it is important to completely melt the granular raw material. For example, in a pulling method which is a representative single-crystal production method, after a granular raw material is melted in a crucible, the crucible is further heated to and maintained at a temperature that is higher by approximately 100°C so as to completely melt the granular raw material, and the temperature is subsequently lowered to a prescribed seed single crystal insertion temperature, after which the seed single crystal is inserted into the resulting melt to initiate the production of a single crystal.

In the production of a silicon single crystal by such a pulling method, however, quartz is used as a crucible material. In this case, the quartz crucible not only is already softened at the melting temperature of silicon but also vigorously reacts with a silicon melt to generate a large amount of silicon monoxide, it is unreasonable to further increase the temperature by approximately 100°C.

Therefore, the single-crystal production is initiated by immersing the seed single crystal as is without further increasing the temperature from the melting temperature. Consequently, needle-like crystals, which are believed to be hardly soluble, remain in the raw material melt, and these needle-like crystals are incorporated into the product, causing the generation of negative crystals.

In order to produce a high-quality single crystal, a raw material melt that does not contain any unmelted granular raw material is required.

Accordingly, the present inventor invented a method of separating a silicon raw material into a completely melted raw material melt and unmelted raw material and supplying only the completely melted melt downward.

In the inclined FZ method, a melt can be formed on the upper surface of a seed single crystal by irradiating the upper surface of the seed single crystal with an infrared ray.

This is the biggest difference from a conventional horizontal FZ method and one of the greatest advantages of the inclined FZ method. A larger inclination angle leads to a further improvement in the melt phase stability; however, as long as the inclination angle is approximately 30°, a sufficiently stable melt phase can be formed and maintained.

The present inventor devised a single-crystal production equipment which, taking advantage of the inclined FZ method, melts and solidify a raw material as is without molding it into a conventional rod shape as described above, as well as a single-crystal production method of producing a large single crystal having a uniform composition using the single-crystal production equipment, thereby completing the present invention.

That is, the single-crystal production equipment of the present invention is a single-crystal production equipment for producing a large single crystal by melting a granular raw material as disclosed in claim 1.

By this configuration, the granular raw material having an optimum composition is continuously supplied to the granular raw material melting apparatus (hereinafter, also simply referred to as "melting apparatus"), and the raw material melt generated by heating and melting the granular raw material is continuously supplied into the melt on the upper surface of the single crystal. It is preferred that the continuous supply of the raw material melt into the melt on the upper surface of the single crystal be performed through the below-described rod-shaped or tubular raw material melt guiding apparatus that connects the melting apparatus with the melt on the upper surface of the seed single crystal.

The mixed melt generated by supplying the raw material melt into the melt formed on the upper surface of the seed single crystal is stably retained on the upper surface of the seed single crystal by surface tension. When the raw material melt is supplied thereto from above, since a solid having the same amount and composition precipitates as a single crystal, the dopant concentration of the resulting single-crystal product is controlled to be the same as that of the raw material melt, so that a single crystal having a uniform composition in both the vertical and horizontal directions at an optimum concentration can be produced.

The single-crystal production equipment of the present invention is characterized in that the granular raw material supply apparatus includes:
a hopper which stores the granular raw material; and
a granular raw material quantitative supply equipment which controls the granular raw material in the hopper to be supplied at a prescribed rate and supplies a certain amount of the granular raw material downward.

The single-crystal production equipment of the present invention is also characterized in that the granular raw material supply apparatus includes a granular raw material scraping equipment which scrapes the granular raw material out of the hopper and supplies the granular raw material downward.

Further, the single-crystal production equipment of the present invention is characterized in that the granular raw material supply apparatus includes a supply pipe through which the granular raw material supplied from the granular raw material quantitative supply equipment is supplied to a prescribed position of the granular raw material melting apparatus below.

Still further, the single-crystal production equipment of the present invention is characterized in that a material of the supply pipe is quartz.

Yet still further, the single-crystal production equipment of the present invention is characterized in that:
an opening is formed on a lower part of the hopper; and
a rotatable spiral rod is arranged inside the hopper.

When the granular raw material is scraped out of the hopper storing the granular raw material, a phenomenon in which a cavity is created in the granular raw material inside the hopper and the granular raw material can thus no longer be taken out of the hopper may occur.

By arranging a spiral rod inside the hopper and rotating this rod in such a manner that the above-described phenomenon is inhibited and the granular raw material can be scraped out stably and continuously, the cavity generation can be inhibited.

Moreover, in order to scrape the granular raw material out of the hopper in a stable manner, for example, a granular raw material scraping equipment in which a receptacle having a spoon-like shape is attached to a tip of a rod is inserted into the opening formed on a lower part of the hopper and subsequently pulled out and then half-rotated to scrape out and drop below the granular raw material collected on the granular raw material scraping equipment, whereby the granular raw material can be taken out of the hopper continuously and stably.

The weight of the granular raw material supplied from the granular raw material scraping equipment is measured, and the granular raw material quantitative supply equipment accurately controls the granular raw material to be supplied at a prescribed rate and supplies the granular raw material through the supply pipe to a prescribed position of the granular raw material melting apparatus below. The material of the supply pipe is not particularly restricted; however, it is desirably quartz in the case of producing a silicon single crystal. Quartz is unlikely to be contaminated with metal impurities.

Yet still further, the single-crystal production equipment of the present invention is characterized in that the hopper includes an attachment-detachment mechanism for attaching and detaching a storage container storing the granular raw material.

Yet still further, the single-crystal production equipment of the present invention is characterized in that the attachment-detachment mechanism has an atmosphere controlling function of arbitrarily controlling the atmosphere inside the attachment-detachment mechanism and the storage container.

Yet still further, the single-crystal production equipment of the present invention is characterized in that the granular raw material melting apparatus and the crystallization apparatus are arranged inside a single-crystal production chamber.

Yet still further, the single-crystal production equipment of the present invention is characterized in that the granular raw material supply apparatus is also arranged inside the single-crystal production chamber.

Yet still further, the single-crystal production equipment of the present invention is characterized by including an atmosphere control equipment which connects the inside of the hopper with the single-crystal production chamber, or controls the inside of the hopper and the single-crystal production chamber to have the same atmosphere.

In this manner, by connecting the storage container storing the granular raw material to the hopper, arbitrarily controlling the atmosphere inside the storage container to be the same as the atmosphere inside the hopper, subsequently transferring the contents of the storage container to the hopper and then removing the storage container, the granular raw material can be added and supplied as desired even in the middle of the single-crystal production; therefore, the size of the hopper can be reduced.

Moreover, with the single-crystal production chamber in which the crystallization apparatus is arranged being connected with the hopper, since the atmosphere inside the hopper and the atmosphere of the crystallization apparatus (i.e., the atmosphere of the single-crystal production chamber) are always the same, the granular raw material can be supplied stably.

It is noted here that the granular raw material supply apparatus including the hopper may also be arranged inside the single-crystal production chamber in the same manner as the granular raw material melting apparatus and the crystallization apparatus.

Yet still further, the production equipment of the present invention is characterized in that the single-crystal production chamber is a water-cooling structure.

With the closed chamber being a water-cooling structure in this manner, deterioration of sealed parts and the like caused by an increase in the temperature of the single-crystal production chamber is inhibited and high-precision atmosphere control can thus be performed efficiently, so that a single crystal can be produced with good yield.

Yet still further, the single-crystal production equipment of the present invention is characterized in that the hopper is constituted by plural hoppers in which granular raw materials having different compositions are each stored.

In the case of strictly producing a single-crystal product having an optimum composition from the beginning of the single-crystal production, a hopper for a granular crystal base material and a hopper for a granular dopant may be separately arranged, and the granular raw material scraping equipment, the granular raw material quantitative supply equipment and the supply pipe may be connected to each of such hoppers.

Then, a dopant-free granular crystal base material and a granular dopant can be supplied while separately controlling their supply amounts to conform to the initial amount of a melt phase to be formed on the upper surface of the seed single crystal. Moreover, by maintaining their compositions to correspond to that of the melt phase while adjusting their amounts in accordance with the amount of the melt phase that increases as the production proceeds, a uniform single crystal having an optimum composition can be produced.

In this case, there is an advantage that it is easy to allow the single-crystal product grown on the seed single crystal to uniformly have an optimum composition from the beginning.

Yet still further, the single-crystal production equipment of the present invention is characterized in that the granular raw material melting apparatus includes:
a granular raw material melting vessel which receives the granular raw material; and
a vessel heating equipment which heats the granular raw material melting vessel and thereby melts the granular raw material in the granular raw material melting vessel.

Yet still further, the single-crystal production equipment of the present invention is characterized in that the granular raw material melting vessel includes:
a melting section where the granular raw material is heated and melted; and
a melt retaining section where only a melt generated in the melting section is retained.

Yet still further, the single-crystal production equipment of the present invention is characterized in that the granular raw material melting vessel is constituted by:
a boat-shaped vessel; and
a separation plate which divides the boat-shaped vessel into the melting section and the melt retaining section and includes a groove on a lower part.

Yet still further, the single-crystal production equipment of the present invention is characterized in that a raw material melt guiding apparatus, which supplies the raw material melt discharged from the granular raw material melting vessel onto the melt formed on the upper surface of the seed single crystal below, is arranged at a lower end of the granular raw material melting vessel.

Examples of embodiments of the granular raw material melting vessel (hereinafter, also simply referred to as "melting vessel") include a structure in which an elongated boat-shaped vessel is divided into a "melting section" and a "melt retaining section" by a separation plate having a groove arranged on a lower part and these sections are each controlled to have an optimum temperature such that, once a granular raw material is melted, the granular raw material remaining unmelted can be separated and only the resulting raw material melt can be supplied to the upper surface of a seed single crystal below.

In this structure, the granular raw material is melted on the outer side of the separation plate; however, the resulting raw material melt moves to the inner side through the groove arranged on a lower part of the separation plate, as a result of which only the raw material melt is discharged from a raw material melt outlet and supplied to the upper surface of the seed single crystal below.

Accordingly, when the specific gravity of the granular raw material is lower than that of the raw material melt obtained by melting the granular raw material, the granular raw material floats on the surface of the raw material melt, whereas when the specific gravity of the granular raw material is higher than that of the raw material melt, the granular raw material sinks to the lower part of the raw material melt, allowing the granular raw material to remain in the melt retaining section.

By constituting the melting vessel by a combination of a boat-shaped vessel and a separation plate in this manner, unmelted granular raw material can be prevented from being supplied as is to the upper surface of the seed single crystal and only the raw material melt can be supplied to the upper surface of the seed single crystal, so that a high-quality single crystal can be produced.

That is, in the process of melting the granular raw material and solidifying the resulting raw material melt as a single crystal, if unmelted granular raw material is incorporated into the raw material melt and adheres to the growth interface between the single crystal and the raw material melt to contaminate the resulting product, this causes the formation of negative crystals when the granular raw material has a small particle size or the generation of new microcrystals when the granular raw material has a large particle size, so that a polycrystal may be produced.

Therefore, it is indispensable that the melting vessel have a function of retaining unmelted granular raw material therein and supplying only completely melted raw material melt to the upper surface of the seed single crystal below.

By this configuration, unmelted granular raw material is prevented from flowing out of the melting vessel through the outlet and thus retained inside the melting vessel.

It is noted here that the raw material melt discharged from the melting vessel may be directly dropped into a melt formed on the upper surface of the single crystal therebelow; however, it is advantageous to supply the raw material melt using a rod-shaped or tubular raw material melt guiding member arranged at a lower end of the melting vessel since this inhibits the occurrence of liquid surface fluctuations caused by addition of droplets and a stable liquid surface is thus maintained, whereby stable single-crystal production can be continuously performed.

Yet still further, the single-crystal production equipment of the present invention is characterized in that the granular raw material melting vessel is constituted by:
a melting dish; and
a separation dish which is arranged inside the melting dish, has an inverted V-shaped cross-section and includes a groove on a lower part, and
the granular raw material melting vessel is configured such that it is divided into the melting section and the melt retaining section between the melting dish and the separation dish.

Yet still further, the single-crystal production equipment of the present invention is characterized in that a raw material melt guiding apparatus, which supplies the raw material melt discharged from the granular raw material melting vessel onto the melt formed on the upper surface of the seed single crystal below, is arranged at a lower end of the granular raw material melting vessel.

Examples of other embodiments of the melting vessel include a two-layer structure (umbrella-like structure) in which a separation dish that has an inverted V-shaped cross-section and a groove on a lower part is arranged inside a melting dish. The "melting section" and the "melt retaining section" are formed between the melting dish and the separation dish.

In this case as well, by arranging a rod-shaped or tubular raw material melt guiding apparatus, which connects the melting vessel with the melt formed on the upper surface of the single crystal arranged therebelow, at a lower end of the melting vessel and supplying the raw material melt through the raw material melt guiding apparatus rather than direct dropping of the raw material melt, the melt on the upper surface of the single crystal can be stably maintained, so that stable single-crystal production can be continuously performed.

Yet still further, the single-crystal production equipment of the present invention is characterized in that the granular raw material melting vessel is constituted by:
a cylindrical section; and
a funnel-shaped section which is arranged inside the cylindrical section and has an opening at a lower end, and
the inner side of the cylindrical section constitutes the melting section and a space between the outer side of the cylindrical section and the funnel-shaped section constitutes the melt retaining section.

In such a simple-type melting vessel, when the specific gravity of a solid material is lower than that of a liquid particularly as in the case of silicon, since unmelted granular raw material floats on the melt, hardly any granular raw material is let out of the melting vessel. Even if the granular raw material is let out, since the granular raw material floats on the melt, it is unlikely that the granular raw material is heated and melted by an infrared ray irradiated from above, adheres to the interface of the growing crystal and is thereby incorporated into the product; therefore, even with this simple-type melting vessel, a single crystal can be produced with good yield.

Yet still further, the single-crystal production equipment of the present invention is characterized in that the vessel heating equipment is a second infrared ray irradiation equipment.

As the vessel heating equipment for heating the melting vessel, a second infrared ray irradiation equipment can be used. For the heating of the melting vessel, an infrared ray may be irradiated to the melting vessel from above, a side, or obliquely below. The melting vessel may be irradiated from a combination of these directions as well.

Yet still further, the single-crystal production equipment of the present invention is characterized in that the vessel heating equipment is a high-frequency induction heating equipment.

As the vessel heating equipment for heating the melting vessel, a high-frequency induction heating equipment can be used. Moreover, the melting vessel may be placed in, for example, a carbon container, and this carbon container can be maintained at a high temperature using the high-frequency induction heating equipment to melt the granular raw material.

Yet still further, the single-crystal production equipment of the present invention is characterized in that the vessel heating equipment is a resistance heating equipment.

As the vessel heating equipment for heating the melting vessel, a resistance heating equipment can be used. For the production of a silicon single crystal, it is convenient to use a carbon resistance heating equipment.

Yet still further, the single-crystal production equipment of the present invention is characterized in that the granular raw material melting vessel includes a melting vessel rotating mechanism which rotates in the horizontal direction.

By incorporating a melting vessel rotating mechanism in this manner, particularly the granular raw material supplied into the melting vessel constituted by the melting dish and the separation dish can be uniformly heated.

Yet still further, the single-crystal production equipment of the present invention is characterized in that a part or the entirety of the granular raw material melting vessel is composed of platinum, iridium, quartz, silicon carbide, carbon, graphite, a carbon or graphite material whose surface has been converted to silicon carbide, or a carbon or graphite material whose surface has been coated with silicon carbide in advance.

With the melting vessel being composed of such a material, the granular raw material can be stably melted to generate the raw material melt. Particularly, for the production of a silicon single crystal, a melting vessel composed of a material obtained by converting the surface of a carbon material into silicon carbide can be suitably used.

Yet still further, the single-crystal production equipment of the present invention is characterized by including the above-described granular raw material supply apparatus in a plural number.

Yet still further, the single-crystal production equipment of the present invention is characterized by including the above-described granular raw material melting apparatus in a plural number.

By incorporating these apparatuses in a plural number, the production rate of a large single crystal can be increased.

Yet still further, the single-crystal production equipment of the present invention is characterized in that a single-crystal holding table, on which the seed single crystal is placed, is arranged on the bottom of the single-crystal production chamber.

Yet still further, the single-crystal production equipment of the present invention is characterized in that the single-crystal holding table includes a holding table rotating mechanism which rotates in the horizontal direction.

With the single-crystal holding table on which the seed single crystal is placed being rotatable, the surface temperature of the melt phase formed by irradiation with an infrared ray can be easily maintained to be uniform, so that an effect of reducing temperature unevenness caused by heating can be attained.

Yet still further, the single-crystal production equipment of the present invention is characterized in that the single-crystal holding table includes an elevator apparatus which moves in the vertical direction at a prescribed speed.

With the seed single crystal being movable in the vertical direction in this manner, the surface of the melt phase being formed can be always maintained at a certain position, so that the distance between an infrared ray irradiation equipment and the surface of the melt phase can be maintained constant at all times.

Yet still further, the single-crystal production equipment of the present invention is characterized in that an auxiliary heating equipment is arranged on the outer side of the seed single crystal.

By arranging an auxiliary heating equipment on the outer side of the seed single crystal and heating the seed single crystal to a temperature lower than its melting point in advance, the irradiation dose of infrared ray can be reduced.

Yet still further, the single-crystal production equipment of the present invention is characterized in that the above-described first infrared ray irradiation equipment is arranged in a plural number.

Yet still further, the single-crystal production equipment of the present invention is characterized in that the above-described second infrared ray irradiation equipment is arranged in a plural number.

By incorporating these infrared ray irradiation equipments in a plural number in this manner, as compared to a case where these equipments are each arranged singly, the melting of the granular raw material and the production of a single crystal can be more stably and surely performed. In addition, by arranging these equipments in a plural number, the melt phase on the upper surface of the seed single crystal can be heated uniformly.

By uniformly heating the upper surface of the melt phase, the resulting solid-liquid interface can be made flat, so that a single-crystal product having a uniform dopant concentration in both the vertical and horizontal directions can be produced.

Yet still further, the single-crystal production equipment of the present invention is characterized in that the first and the second infrared ray irradiation equipments are laser irradiation equipments irradiating laser light.

The use of laser irradiation equipments irradiating laser light in this manner can contribute to downsizing and improvement in operability of the single-crystal production equipment.

Yet still further, the single-crystal production equipment of the present invention is characterized in that the first and the second infrared ray irradiation equipments each include:
an elliptical reflector whose inner surface is used as a reflection surface; and
an infrared lamp which is arranged at a first focus position on the bottom side of the elliptical reflector.
By using such infrared ray irradiation equipments, infrared ray can be efficiently irradiated.

Yet still further, the single-crystal production equipment of the present invention is characterized in that the infrared lamp is a halogen lamp or a xenon lamp.

Since a halogen lamp or a xenon lamp can be obtained inexpensively, the production cost of the production equipment can be reduced.

Yet still further, the single-crystal production equipment of the present invention is characterized in that infrared ray transmitting windows, which transmit the above-described infrared ray, are arranged between the seed single crystal and granular raw material melting vessel and each of the first and second infrared ray irradiation equipments.

With the infrared ray transmitting windows being arranged in this manner, even if the raw material melt is evaporated in the single-crystal production chamber, the resulting evaporant does not reach the respective infrared ray irradiation equipments; therefore, the equipments can be stably used over a long period without reduction in the intensity of the infrared ray. In such a case where the evaporant adheres to the infrared ray transmitting windows, it is preferred to arrange an evaporant adhesion-inhibiting apparatus on the periphery of each infrared ray transmission window. As the evaporant adhesion-inhibiting apparatus, for example, an atmosphere gas may be sprayed to each infrared ray transmitting window.

The single-crystal production method is a single-crystal production method of producing a high-quality single-crystal product having a uniform composition by melting a granular raw material, which has an optimum dopant composition of a single-crystal material to be produced, in a single-crystal production chamber, adding dropwise the thus obtained raw material melt into a melt formed on the upper surface of a seed single crystal arranged therebelow so as to generate a mixed melt, and then allowing a single crystal to precipitate out of the mixed melt as a solid,
wherein the single-crystal production method includes, at least, the steps of:
supplying a required amount of the granular raw material to a granular raw material melting apparatus via a granular raw material supply apparatus arranged above the single-crystal production chamber;
preparing a raw material melt by melting the granular raw material thus supplied to the granular raw material melting apparatus using the granular raw material melting apparatus;
supplying the thus obtained raw material melt into a melt formed on the seed single crystal below; and
irradiating the upper surface of the seed single crystal with an infrared ray to form a melt, subsequently generating a mixed melt phase by adding dropwise the raw material melt to the thus formed melt from the granular raw material melting apparatus, and then allowing a single crystal to precipitate as a solid on the seed single crystal from the lower side of the mixed melt phase.

The single-crystal production method is characterized in that the granular raw material is composed of a granular crystal base material and a granular dopant material.

Further, the single-crystal production method is characterized in that, during production of a dopant-doped single crystal, the intensity and the distribution of the infrared ray irradiated to the upper surface of the seed single crystal are controlled such that the mixed melt formed on the seed single crystal uniformly has a prescribed thickness at all times.

The steps of producing an N-type silicon single crystal doped with phosphorus at an optimum composition will now be described as an example.

In the step of supplying a granular raw material to a granular raw material melting apparatus, a dopant-free silicon granular raw material and a phosphorus-doped granular raw material whose average composition has a phosphorus concentration of 10 times higher than an optimum dopant concentration are mixed to prepare a granular raw material having an optimum composition, and this granular raw material is stored in a hopper.

A granular raw material scraping equipment and a granular raw material quantitative supply equipment are put into operation, and a prescribed amount of the granular raw material is supplied from the hopper through a supply pipe into a granular raw material melting vessel of a granular raw material melting apparatus arranged therebelow.

In the step of preparing a raw material melt by melting the granular raw material using the granular raw material melting apparatus, the granular raw material is added from above to the melting vessel that has been heated by a vessel heating equipment in advance, and melted in the melting vessel.

Next, in the step of supplying the thus obtained raw material melt into a melt formed on the seed single crystal below, only the completely melted raw material melt is supplied into a melt formed on the upper surface of the seed single crystal. It is noted here that the supply of the raw material melt into the melt formed on the upper surface of the seed single crystal is preferably made through a rod-shaped or tubular raw material melt guiding apparatus which extends from the lower end of the granular raw material melting vessel to immediately above the seed single crystal. By this, the occurrence of liquid surface fluctuations caused by addition of droplets can be inhibited, so that a stable liquid surface can be maintained.

In the step of allowing a single crystal to precipitate, the seed single crystal is placed on a single-crystal holding table, and the granular raw material, which can yield an optimum melt having such a composition and an amount that are required for the formation of a solid having an optimum dopant concentration in a steady state, is arranged on the seed single crystal, after which the inside of the single-crystal production chamber is vacuum-evacuated and argon gas is subsequently introduced thereto.

The seed single crystal is rotated while maintaining the inside of the single-crystal production chamber under a prescribed reduced pressure, and a first infrared ray irradiation equipment for heating the upper surface of the seed single crystal is operated to form an optimum melt phase.

The raw material melt starts to be supplied to the seed single crystal from above, and the single-crystal holding table is lowered as a solid precipitates in an amount conforming to the supply amount.

Once the addition of the prescribed granular raw material is completed, the operations of the granular raw material scraping equipment, the granular raw material quantitative supply equipment and the vessel heating equipment are terminated, the lowering of the single-crystal holding table is stopped, and the output of the first infrared ray irradiation equipment is slowly reduced, whereby the melt phase is allowed to solidify completely.

Then, the irradiation of infrared ray is completely terminated and, once the resulting crystal is cooled to room temperature over a prescribed cooling period, all of the operating components are stopped, and a door of the single-crystal production chamber is opened to take out a single-crystal product.

As a result, a high-quality large single crystal which has a uniform dopant concentration with an optimum composition in both the vertical and horizontal directions can be obtained.

### Advantageous Effects of Invention

According to the single-crystal production equipment of the present invention, a large single crystal which uniformly has an optimum-concentration composition in both the vertical and horizontal directions can be produced by supplying a granular raw material uniformly containing a dopant having an optimum composition to the upper surface of a seed single crystal at a prescribed rate.

### Brief Description of Drawings

[FIG. 1] FIG. 1 is a schematic view showing a single-crystal production equipment according to one embodiment of the present invention.
[FIG. 2] FIG. 2 is a schematic view showing a single-crystal production equipment according to another embodiment of the present invention.
[FIG. 3] FIG. 3 is a schematic view showing a boat-type granular raw material melting vessel according to one embodiment of the present invention.
[FIG. 4] FIG. 4 is a schematic view showing a granular raw material melting vessel having a two-layer structure (umbrella-like structure) according to another embodiment of the present invention.
[FIG. 5] FIG. 5 is a schematic view showing a simple-type granular raw material melting vessel according to yet another embodiment of the present invention.
[FIG. 6] FIG. 6 is a set of drawings showing the production steps of a single crystal using the single-crystal production equipment of the present invention.

### Description of Embodiments

Embodiments (examples) of the present invention will now be described in more detail based on the drawings.

The single-crystal production equipment and single-crystal production method according to the present invention are used for highly efficiently producing a large single crystal of, for example, 100 to 300 mm or larger in diameter, while homogenizing its composition to be optimum.

The term "seed single crystal" used herein refers to an initial form of a crystal in the production of a large-diameter single crystal using a single-crystal production equipment. A crystal which is grown from this seed single crystal and maintains the same orientation in its entirety is referred to as "single crystal". In contrast, an aggregate of single crystals each having a different orientation is referred to as "polycrystal".

In the case of a polycrystal, individual single crystals have different crystal orientations at their boundaries, and this leads to disadvantages such as reduction in the power generation efficiency. Therefore, a high-performance silicon substrate is desired to be a single crystal which entirely has the same orientation and thus does not contain such crystal grain boundaries.

Further, the term "granular raw material" used herein refers to a powderized (granulated) raw material from which a single crystal is produced. It is noted here that the term "granular raw material" encompasses granular crystal base materials and granular dopants.

In the production of a dopant-containing single crystal, the dopant concentration in the resulting crystal does not agree with the composition of a melt from which the crystal (solid) having this concentration precipitates. The ratio between the dopant concentration in a solution and that in a solid precipitating from the solution is referred to as "distribution coefficient", and the solution used in this case is referred to as "solvent" in the discipline of crystal growth.

Theoretically, a solid having the same composition as a raw material should precipitate out of a solvent defined by the composition of the raw material and the distribution coefficient; however, strictly speaking, the composition of a mixed melt formed by a melt formed on the resulting single crystal and a raw material melt dropped thereto is actually different between a part where the raw material melt is dropped and a part away therefrom. Therefore, in the present specification, the term "solvent" is not used, and the term "mixed melt" is used instead.

Further, in the drawings, the size and the shape of the particles representing the granular raw material are not particularly restricted.

### <Single-Crystal Production Equipment 10>

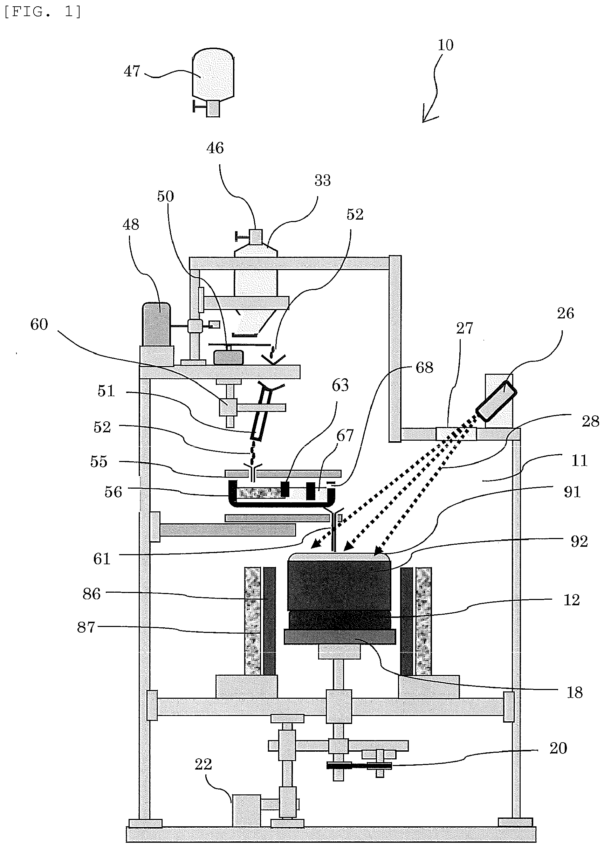

As shown in FIG. 1, a single-crystal production equipment 10 of the present Example assumes a case of producing a silicon single crystal having an optimum dopant composition.

In the single-crystal production equipment 10, a single-crystal holding table 18, a holding table rotating mechanism 20 and an elevator apparatus 22 are arranged on the bottom of a single-crystal production chamber 11 which can be vacuum-evacuated and retain an inert gas atmosphere such as argon gas, and a seed single crystal 12 having a substantially circular cross-sectional shape is placed on the single-crystal holding table 18.

Further, on the outer side of the single-crystal holding table 18, an auxiliary heating equipment 86 which heats the seed single crystal 12 placed on the single-crystal holding table 18 is arranged, and an insulating material 87 is arranged on the outer side of the auxiliary heating equipment 86. The single-crystal production chamber 11 is a water-cooling structure which is capable of efficiently controlling the inner atmosphere.

Meanwhile, in the upper part of the single-crystal production chamber 11, a hopper 33 which stores a granular raw material 52 is arranged. The hopper 33 has an opening on its lower part, and a spiral rod (not shown), which is equipped with a rotating mechanism and coated with polypropylene, is arranged inside the hopper 33 and rotated at all times during use. By rotating this spiral rod, the occurrence of a so-called cavitation phenomenon where a cavity is created in the granular raw material 52 stored in the hopper 33 and stable supply of the granular raw material 52 is thereby made no longer possible can be inhibited.

The opening on the lower part of the hopper 33 is directly connected to the single-crystal production chamber 11, and the hopper 33 and the single-crystal production chamber 11 are configured in such a manner to have the same internal atmosphere at all times.

Moreover, on a lateral side of the opening of the hopper 33, a granular raw material scraping equipment (hereinafter, also simply referred to as "scraping equipment") 48 is arranged. This scraping equipment 48 includes a propylene-coated receptacle having a spoon-like shape that is attached to a tip of a rod, and it is configured such that, by inserting this rod to the opening of the hopper 33 and then pulling out and half-rotating the rod with the granular raw material 52 being placed in the receptacle, the granular raw material 52 in the receptacle can be supplied onto a granular raw material quantitative supply equipment (hereinafter, also simply referred to as "quantitative supply equipment") 50 positioned underneath the hopper 33.

The quantitative supply equipment 50 adjusts the amount of the granular raw material 52 to be supplied while measuring the weight thereof and supplies a prescribed amount of the granular raw material 52 to a supply pipe 51 therebelow which has a supply position adjusting function. In the drawing, a symbol 60 represents a position adjusting mechanism.

The hopper 33 in this embodiment stores a granular mixture obtained by mixing dopant-free granular silicon and a granular raw material doped with a dopant at a high concentration such that the granular mixture has an optimum composition, and this enables to surely maintain the composition ratio of the granular raw material 52 constant.

In this embodiment, the hopper 33 is used singly; however, the configuration is not restricted to this mode and, for example, a hopper for storing the dopant-free granular silicon and a hopper for storing the granular raw material doped with a dopant at a high concentration may be separately arranged.

At the upper end of such hopper 33, a known attachment-detachment mechanism 46 is arranged such that a storage container 47 which stores the granular raw material 52 can be attached and detached as desired. The attachment-detachment mechanism 46 includes an atmosphere controlling function for arbitrarily controlling the atmospheres inside the attachment-detachment mechanism 46 and the storage container 47. FIG. 1 shows a state where the storage container 47 is detached from the hopper 33.

By using the storage container 47 that can be attached to and detached from the hopper 33 in this manner, the granular raw material 52 can be supplied to the hopper 33 at any time as required even in the midst of operating the single-crystal production equipment 10 to produce a single crystal. Therefore, it is not necessary to use a large hopper 33, and a reduction in the size of the single-crystal production equipment 10 can be realized.

The granular raw material 52 supplied from the scraping equipment 48 is supplied to a prescribed position of a granular raw material melting vessel (hereinafter, also referred to as "melting vessel") 56 of a granular raw material melting apparatus through the supply pipe 51 in a prescribed amount using the quantitative supply equipment 50 which has a function of adjusting the supply amount while measuring the weight.

To the supply pipe 51, the position adjusting mechanism 60, which adjusts the position of an outlet at the lower end of the supply pipe 51, is attached.

It is preferred that the melting vessel 56, which melts the granular raw material 52, have a multi-section structure divided into a "melting section" where the granular raw material 52 is melted and a "melt retaining section" where the resulting melt is retained; and that the melting vessel 56 have a function of preventing unmelted granular raw material 52 from being supplied downward along with the raw material melt 67.

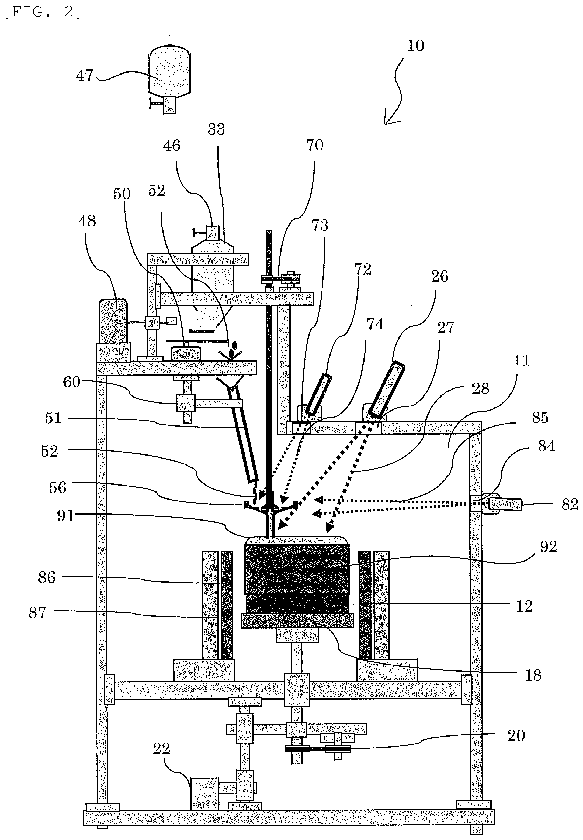

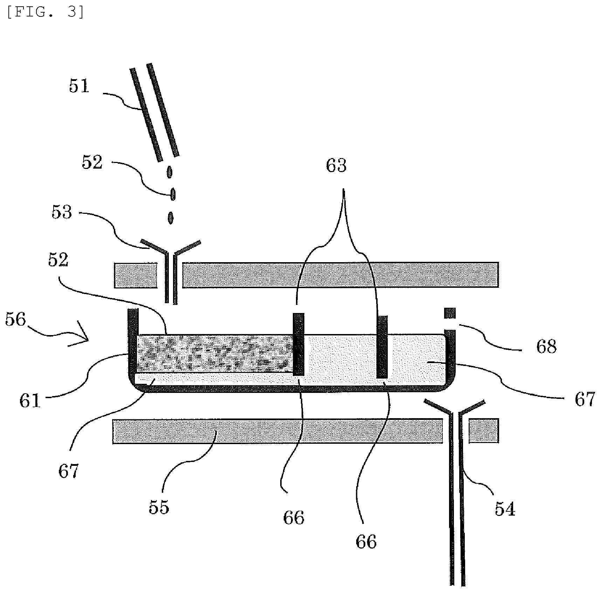

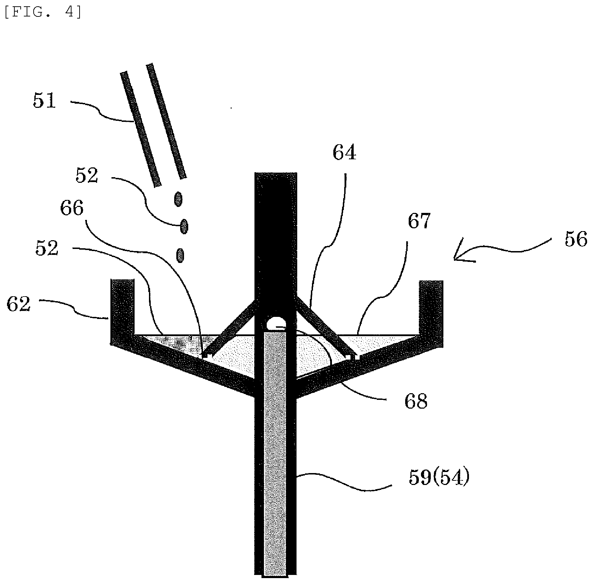

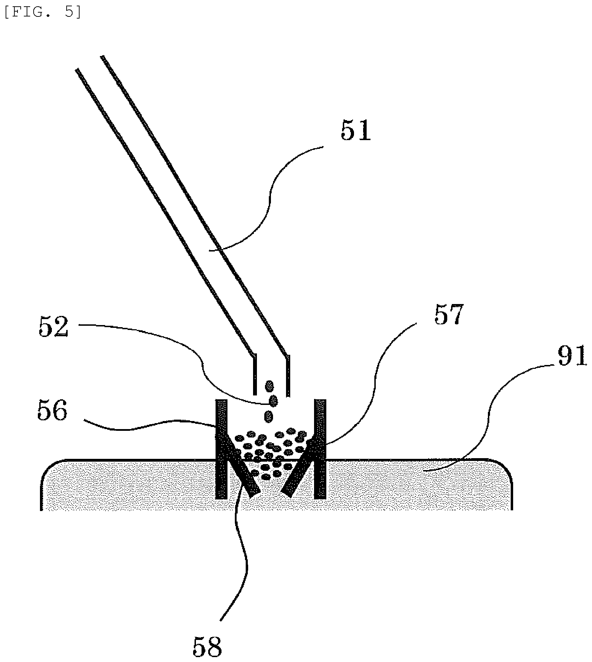

As for the shape of the melting vessel 56, for example, such a boat-type melting vessel 56 as shown in FIGs. 1 and 3 or such a melting vessel 56 having a two-layer structure (umbrella-like structure) as shown in FIGs. 2 and 4 can be utilized. Further, in the case of producing a silicon single crystal, such a simple-type melting vessel 56 as shown in FIG. 5 can be utilized as well.

First, in the boat-type melting vessel 56, as shown in FIG. 3, a boat-shaped vessel 61 which receives the granular raw material 52 supplied from the supply pipe 51 is fitted inside a high-frequency induction heating equipment 55. A separation plate 63 having a groove 66 on a lower part is arranged inside the boat-shaped vessel 61, and the boat-shaped vessel 61 is divided by the separation plate 63 into the "melting section" and the "melt retaining section".

The granular raw material 52 to be supplied to the boat-shaped vessel 61 through the supply pipe 51 may be directly supplied into the boat-shaped vessel 61; however, it is preferred to supply the granular raw material 52 into the boat-shaped vessel 61 using a funnel for granular raw material 53 since this makes it easier to supply the granular raw material 52 at a prescribed position.

By induction heating performed by the high-frequency induction heating equipment 55, the temperature of the boat-shaped vessel 61 is increased, and the granular raw material 52 is thereby heated and melted, as a result of which only the thus formed raw material melt 67 moves to an adjacent section (the section on the right in FIG. 3) through the groove 66 on the lower part of the separation plate 63 and is retained therein.

At this point, when the granular raw material 52 has a lower specific gravity than the raw material melt 67, since the granular raw material 52 floats on the raw material melt 67, the granular raw material 52 is prevented from passing through the groove 66 below. On the other hand, when the specific gravity of the granular raw material 52 is higher than that of the raw material melt 67, the granular raw material 52 stays in a lower part of the raw material melt 67.

Once the raw material melt 67 retained in the boat-shaped vessel 61 has reached the height of an outlet 68 arranged on the boat-shaped vessel 61, the raw material melt 67 flows to the outside through the outlet 68 and is thereby supplied onto the seed single crystal below. The raw material melt 67 discharged from the outlet 68 is preferably supplied onto the seed single crystal 12 below through a tubular or rod-shaped (not shown) raw material melt guiding apparatus 54 which, as shown in FIG. 3, extends from the lower end of the boat-shaped vessel 61 to immediately above the seed single crystal 12. By this, the occurrence of liquid surface fluctuations caused by addition of droplets can be inhibited, so that a stable liquid surface can be maintained.

In this case, in the boat-type melting vessel 56, the unmelted granular raw material 52 can be prevented from being supplied downward along with the raw material melt 67.

Meanwhile, as shown in FIG. 4, the melting vessel 56 having a two-layer structure (umbrella-like structure) is constituted by a melting dish 62 and a separation dish 64 which is disposed thereon in such a manner to have an inverted V-shaped cross-section, and this melting vessel 56 is configured in such a manner to be divided between the melting dish 62 and the separation dish 64 into a melting section where the granular raw material 52 is melted and a melt retaining section where the resulting raw material melt 67 is retained.

As vessel heating equipments for heating the granular raw material 52 supplied to the melting dish 62, as shown in FIG. 2, second infrared ray irradiation equipments 72 and 82 are used, and infrared rays 74 and 85 are irradiated to the melting vessel 56 from these second infrared ray irradiation equipments 72 and 82.

It is preferred that the second infrared ray irradiation equipments 72 and 82 be arranged above and on a side of the melting vessel 56 as shown in FIG. 2, respectively; however, they may both be arranged either above or on a side of the melting vessel 56. As the second infrared ray irradiation equipments 72 and 82, laser irradiation equipments are preferably used; however, other than laser irradiation equipments, the second infrared ray irradiation equipments 72 and 82 may also be resistance heating equipments (particularly, carbon resistance heating equipments in the case of producing a silicon single crystal), or irradiation apparatuses configured such that, for example, an infrared ray emitted from an infrared lamp is reflected by the inner surface of an elliptical reflector. In this case, as the infrared lamp, a halogen lamp, a xenon lamp or the like can be used.

In the melting vessel 56 having a two-layer structure (umbrella-like structure), by the infrared rays irradiated from the second infrared ray irradiation equipments 72 and 82, the granular raw material 52 is heated and melted, and only the resulting raw material melt 67 moves to the central part through a groove 66 arranged at the lower end of the separation dish 64 and is retained in the separation dish 64.

At this point, when the granular raw material 52 has a lower specific gravity than the raw material melt 67, since the granular raw material 52 floats on the raw material melt 67, the granular raw material 52 is prevented from passing through the groove 66 below.

On the other hand, when the specific gravity of the granular raw material 52 is higher than that of the raw material melt 67, the granular raw material 52 stays in a lower part of the raw material melt 67.

The raw material melt 67 retained in the separation dish 64 remains in the central part and, once the raw material melt 67 has reached the height of an outlet 68 arranged on a pipe 59 in the central part, the raw material melt 67 flows into the pipe 59 through the outlet 68 and is thereby supplied onto the upper surface of the seed single crystal below. By this, the unmelted granular raw material 52 can be prevented from dripping down along with the raw material melt 67.

The pipe 59 arranged in the central part extends to immediately above the seed single crystal 12 and functions as the raw material melt guiding apparatus 54. By this, the occurrence of liquid surface fluctuations caused by addition of droplets can be inhibited, so that a stable liquid surface can be maintained.

Further, as shown in FIG. 5, the simple-type melting vessel 56 stores the granular raw material 52 supplied from the upper end and is constituted by a cylindrical section 57, whose lower end is inserted into an optimum melt 91 on the upper surface of the seed single crystal 12, and a funnel-shaped section 58, which is arranged inside the cylindrical section 57 and has an opening at the lower end.

In this simple-type melting vessel 56, particularly as in the case of silicon, when the specific gravity of the granular raw material 52 is lower than that of the raw material melt 67, since the unmelted granular raw material 52 floats on the melt in the cylindrical section 57, hardly any granular raw material 52 is let out of the melting vessel 56.

Even if the granular raw material 52 is let out, since the granular raw material 52 floats on the melt, it is unlikely that the granular raw material 52 is heated and melted by an infrared ray irradiated from above, adheres to the interface of the growing crystal and is thereby incorporated into the product.

As vessel heating equipments for heating this melting vessel 56, the second infrared ray irradiation equipments 72 and 82 may be used as in the case of the melting vessel 56 having a two-layer structure (umbrella-like structure) shown in FIG. 2.

As the material of the above-described boat-type melting vessel 56, melting vessel 56 having a two-layer structure (umbrella-like structure) and simple-type melting vessel 56, for example, platinum, iridium, quartz, silicon carbide, carbon, graphite, a carbon or graphite material whose surface has been converted to silicon carbide, or a carbon or graphite material whose surface has been coated with silicon carbide in advance, is selected in accordance with the raw material.

The melting vessel 56 having a two-layer structure (umbrella-like structure) has a function of being rotated in the horizontal direction by a melting vessel rotating mechanism 70. By rotating the melting vessel 56 having a two-layer structure (umbrella-like structure) in this manner, the granular raw material 52 is evenly supplied from the supply pipe 51 into the melting vessel 56, so that the granular raw material 52 can be surely melted.

Meanwhile, a seed single crystal holding table (hereinafter, also simply referred to as "holding table") 18 is arranged in the lower part of the single-crystal production chamber 11.

Further, the auxiliary heating equipment 86 is arranged on the outer side of the holding table 18, and the periphery of the auxiliary heating equipment 86 is constituted by the insulating material 87.

The seed single crystal 12 is placed on the holding table 18, and the holding table 18 is rotated at a prescribed speed by the holding table rotating mechanism 20, whereby uneven irradiation of the upper surface of the seed single crystal 12 with the infrared ray (laser light) is reduced, and the resulting melt phase is thus allowed to have uniform temperature.

Further, the elevator apparatus 22 is attached to the holding table 18. This provides a configuration in which the height position of the melt phase formed on the upper surface of the seed single crystal 12 can be controlled to be optimal at all times.

Moreover, infrared ray transmitting windows 27, 73 and 84 are each arranged between the seed single crystal 12 and a first infrared ray irradiation equipment 26 for heating the seed single crystal 12 and between the melting vessel 56 and the respective second infrared ray irradiation equipments 72 and 82. The material of these infrared ray transmitting windows 27, 73 and 84 is not particularly restricted as long as it can transmit infrared rays; however, the infrared ray transmitting windows 27, 73 and 84 are preferably made of, for example, quartz.

The single-crystal production equipment 10 according to one embodiment of the present invention is configured as described above, particularly in such a manner that the granular raw material 52 is converted into the raw material melt 67 using the boat-type melting vessel 56, the melting vessel 56 having a two-layer structure (umbrella-like structure) or the simple-type melting vessel 56 and only the raw material melt 67 is supplied to the upper surface of the seed single crystal 12; therefore, the single-crystal production equipment 10 is capable of producing a high-quality large single crystal with no negative crystal or crystal grain boundary, which has a uniform composition in both the vertical and horizontal directions at an optimum dopant concentration.

Furthermore, since the single-crystal production equipment 10 of the present invention includes no crucible, it is capable of producing a high-quality single crystal with no contamination from a crucible and without the generation of exsolution lamellae, which is one of the most serious defects in the case of, for example, using silicon.

### <Single-Crystal Production Method>

A single-crystal production method using the single-crystal production equipment 10 will now be described.

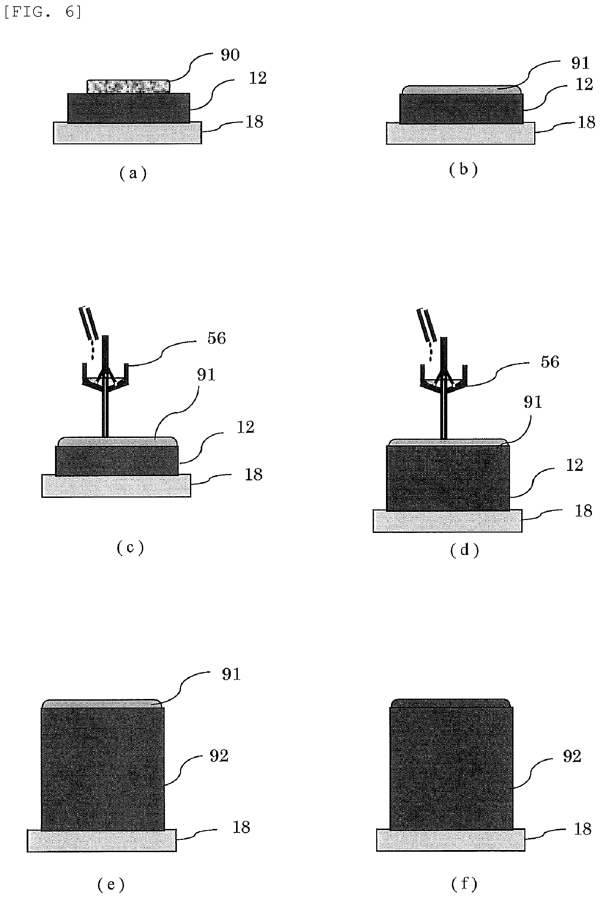

As shown in FIG. 6(a), the seed single crystal 12 is placed on the holding table 18 in the single-crystal production chamber 11.

Next, a granular raw material pellet for optimum melt 90, which is prepared estimating the composition and the amount of an optimum melt phase to be formed, is placed on the upper surface of the seed single crystal 12. The single-crystal production chamber 11 is hermetically sealed, and the atmosphere inside the single-crystal production chamber 11 is vacuum-evacuated by a gas evacuation unit (not shown), followed by introduction of an inert atmosphere, such as argon gas, into the single-crystal production chamber 11.

Further, as shown in FIG. 6(b), an optimum melt phase composed of the optimum melt 91 is formed by irradiating an infrared ray 28 to the upper surface of the seed single crystal 12 from the first infrared ray irradiation equipment 26.

Subsequently, as shown in FIG. 6(c), the scraping equipment 48, the quantitative supply equipment 50 and the vessel heating equipment, which are positioned above the seed single crystal 12, are put into operation so as to scrape the granular raw material 52 having an optimum composition out of the hopper 33, feed the granular raw material 52 into the melting vessel 56 through the supply pipe 51 at a prescribed rate, and supply the resulting raw material melt 67 into the optimum melt 91 on the upper surface of the seed single crystal 12.

As the thickness of a mixed melt formed by the supply of the raw material melt 67 to the optimum melt 91 on the upper surface of the seed single crystal 12 increases, the infrared ray 28 becomes less likely to reach therebelow and, therefore, the temperature in the vicinity of a solid-liquid interface underneath the optimum melt 91 is lowered, as a result of which a solid phase starts to precipitate on the seed single crystal 12 as shown in FIG. 6(d).

The operation of feeding the granular raw material 52 having an optimum dopant composition to the melting vessel 56 is continuously performed. As shown in FIG. 6(e), the solid phase continues to precipitate in the lower part of the optimum melt phase of the seed single crystal 12, whereby a single crystal 92 continues to grow.

Once the prescribed supply of the granular raw material 52 is completed, the output of the first infrared ray irradiation equipment 26 is slowly lowered.

Then, as shown in FIG. 6(f), a complete single crystal 92 is formed as a whole.

After the completion of the single crystal 92, the temperature is slowly lowered, and the single-crystal production chamber 11 is cooled to room temperature and then opened, after which the single crystal 92 on the holding table 18 is taken out as a product.

It is noted here that, in this embodiment, the irradiation dose distribution of the infrared ray 28 is designed such that the surface of the single crystal 92 can be maintained as flat as possible throughout the production process.

In the single-crystal production equipment 10 and the single-crystal production method according to the present invention, a granular raw material obtained by mixing the granular raw material 52 composed of a granular crystal base material (granular silicon) and a granular dopant material at an optimum composition is used. This mixed granular raw material 52 having an optimum composition is stored in the hopper 33 and, using the scraping equipment 48 and the quantitative supply equipment 50, the granular raw material 52 is dropped therefrom through the supply pipe 51 into the melting vessel 56, and only the resulting raw material melt 67 is supplied to the upper surface of the seed single crystal 12 below, whereby the processes from the supplying and the melting of the granular raw material 52 to the solidification of the single crystal 92 are continuously performed.

In other words, in a steady state, the granular raw material 52, which is continuously supplied into the melting vessel 56, is heated and melted to obtain the raw material melt 67, and the single crystal 92 is precipitated by supplying the thus obtained raw material melt 67 to the upper surface of the seed single crystal 12; therefore, the resulting single crystal 92 has the same composition as that of the granular raw material 52 having an optimum composition.

Accordingly, the crystal being produced is allowed to uniformly have an optimum composition.

This enables to produce, for example, a high-quality single crystal having a uniform composition at a dopant concentration that allows the single crystal to realize a high conversion efficiency when used for photovoltaic power generation. A single crystal having an optimum composition can thus be produced with good yield, and this consequently contributes to a reduction of the production cost.

The single-crystal production equipment 10 of the present invention and a single-crystal production method using the single-crystal production equipment 10 have been described thus far; however, the present invention is not restricted to the above-described embodiments.

In the above-described embodiments, for the production of an N-type semiconductor, a mixed granular raw material, which is obtained by mixing a dopant-free high-purity silicon granular raw material and a granular raw material doped with phosphorus at a high concentration such that the resultant has a prescribed optimum composition, is used.

For the production of a P-type semiconductor, similarly, a mixed granular raw material, which is obtained by mixing a dopant-free high-purity silicon granular raw material and a granular raw material doped with boron at a high concentration such that the resultant has a prescribed optimum composition, is used.

When a dopant-free high-purity granular silicon and a granular raw material doped with phosphorus, boron or the like at a high concentration are separately supplied, there is an advantage that the dopant concentration in the product can be changed as appropriate. However, in most cases, since the optimum concentration is known, it is efficient to prepare a granular raw material (granular silicon material + granular dopant material) 52 that has a composition ratio conforming to the optimum concentration and to supply this granular raw material 52 at once.

Further, in the above-described embodiments, no particular mention is made on the particle size of the granular raw material 52 and the like; however, when the particle size of the granular raw material 52 is excessively large, it may take time to melt the granular raw material 52. On the other hand, an excessively small particle size is likely to cause inconvenience such as scattering of the granular raw material 52 during the supply.

Therefore, the particles of the granular raw material 52 preferably have a size of approximately 0.1 to 0.5 mm in diameter.

Moreover, in the above-described embodiments, a case where a dopant-free high-purity silicon granular raw material 52 is used as the granular crystal base material was described as an example, the granular crystal base material is not restricted thereto, and any granular raw material 52 prepared in accordance with the substance to be produced can be used.

Furthermore, in the above-described embodiments, plural first infrared ray irradiation equipments 26 each of which irradiates an infrared ray may be arranged, and the scraping equipment, the quantitative supply equipment, the supply pipe, the melting vessel and the vessel heating equipment may also each be arranged in a plural number. Defining the scraping equipment, the quantitative supply equipment, the supply pipe, the melting vessel and the vessel heating equipment as a single set, it is preferred to arrange the set in a plural number.

In the above-described manner, a variety of modifications can be made in the single-crystal production equipment 10 of the present invention within the scope of the appended claims.

### Reference Signs List

- 10:: single-crystal production equipment
- 11:: single-crystal production chamber
- 12:: seed single crystal
- 18:: single-crystal holding table
- 20:: holding table rotating mechanism
- 22:: elevator apparatus
- 26:: first infrared ray irradiation equipment
- 27:: infrared ray transmitting window
- 28:: infrared ray
- 33:: hopper
- 46:: attachment-detachment mechanism
- 47:: storage container
- 48:: granular raw material scraping equipment
- 50:: granular raw material quantitative supply equipment
- 51:: supply pipe
- 52:: granular raw material
- 53:: funnel for granular raw material
- 54:: raw material melt guiding apparatus
- 55:: high-frequency induction heating equipment
- 56:: melting vessel
- 57:: cylindrical section
- 58:: funnel-shaped section
- 59:: pipe
- 60:: position adjusting mechanism
- 61:: boat-shaped vessel
- 62:: melting dish
- 63:: separation plate
- 64:: separation dish
- 66:: groove
- 67:: raw material melt
- 68:: outlet
- 70:: melting vessel rotating mechanism
- 72:: second infrared ray irradiation equipment
- 73:: infrared ray transmitting window
- 74:: infrared ray
- 82:: second infrared ray irradiation equipment
- 84:: infrared ray transmitting window
- 85:: infrared ray
- 86:: auxiliary heating equipment
- 87:: insulating material
- 90:: granular raw material pellet for optimum melt
- 91:: optimum melt
- 92:: single crystal

## Claims

1. A single-crystal production equipment for producing a large single crystal by melting a granular raw material using a granular raw material melting apparatus, supplying the thus obtained raw material melt into a melt formed on the upper surface of a seed single crystal below to generate a mixed melt, and then allowing a solid to precipitate out of said mixed melt as a single crystal,
wherein said single-crystal production equipment comprises, at least:
a granular raw material supply apparatus which supplies a certain amount of said granular raw material downward;
said granular raw material melting apparatus which heats and melts said granular raw material supplied from said granular raw material supply apparatus and supplies the thus obtained raw material melt downward; and
a crystallization apparatus which allows a single crystal to precipitate out of said mixed melt that is formed upon receiving a melt formed by irradiating an infrared ray from a first infrared ray irradiation equipment to the upper surface of said seed single crystal and said raw material melt supplied from said granular raw material melting apparatus.
wherein said granular raw material melting apparatus comprises:
a granular raw material melting vessel which receives said granular raw material (52), and
a vessel heating equipment which heats said granular raw material melting vessel and thereby melts said granular raw material melting vessel;
wherein said granular raw material melting vessel comprises:
a melting section where said granular raw material (52) is heated and melted; and
a melt retaining section where only a melt generated in said melting section is retained; and
wherein said granular raw material melting vessel is selected from the group consisting of:
- a boat-shaped vessel (61), and
a separation plate (63) which divides said boat-shaped vessel (61)) into said melting section and said melt retaining section and comprises a groove (66) on a lower part,
wherein the raw material melt guiding apparatus, which supplies said raw material melt (67) discharged from said granular raw material melting vessel onto said melt formed on the upper surface of said seed single crystal (12) below, is arranged at a lower end of said granular raw material melting vessel, or
- a melting dish (62), and
a separation dish (64) which is arranged inside said melting dish (62), has an inverted V-shaped cross-section and comprises a groove on a lower part, and
said granular raw material melting vessel is configured such that it is divided into said melting section and said melt retaining section between said melting dish (62) and said separation dish (64),
wherein the raw material melt guiding apparatus, which supplies said raw material (67) melt discharged from said granular raw material melting vessel onto said melt formed on the upper surface of said seed single crystal (12) below, is arranged at a lower end of said granular raw material melting vessel, or
- wherein said granular raw material melting vessel is constituted by:
a cylindrical section (57), and
a funnel-shaped section (58) which is arranged inside said cylindrical section (57) and has an opening at a lower end, and
the inner side of said cylindrical section (57) constitutes said melting section and a space between the outer side of said cylindrical section (57) and said funnel-shaped section (58) constitutes said melt retaining section.

2. The single-crystal production equipment according to claim 1, wherein said granular raw material supply apparatus comprises:
a hopper which stores said granular raw material; and
a granular raw material quantitative supply equipment which controls said granular raw material in said hopper to be supplied at a prescribed rate and supplies a certain amount of said granular raw material downward.

3. The single-crystal production equipment according to claim 1 or 2, wherein said granular raw material supply apparatus comprises a granular raw material scraping equipment which scrapes said granular raw material out of said hopper and supplies said granular raw material downward.

4. The single-crystal production equipment according to claim 2 or 3, wherein said granular raw material supply apparatus comprises a supply pipe through which said granular raw material supplied from said granular raw material quantitative supply equipment is supplied to a prescribed position of said granular raw material melting apparatus below.

5. The single-crystal production equipment according to claim 4, wherein a material of said supply pipe is quartz.

6. The single-crystal production equipment according to claim 2, wherein said hopper comprises an attachment-detachment mechanism for attaching and detaching a storage container storing said granular raw material.

7. The single-crystal production equipment according to claim 6, wherein said attachment-detachment mechanism has an atmosphere controlling function of arbitrarily controlling the atmosphere inside said attachment-detachment mechanism and said storage container.

8. The single-crystal production equipment according to any one of claims 1 to 7, wherein said granular raw material melting apparatus and said crystallization apparatus are arranged inside a single-crystal production chamber.

9. The single-crystal production equipment according to claim 8, wherein said granular raw material supply apparatus is arranged inside said single-crystal production chamber.

10. The single-crystal production equipment according to claim 8 or 9, comprising an atmosphere control equipment which connects the inside of said hopper with said single-crystal production chamber, or controls the inside of said hopper and said single-crystal production chamber to have the same atmosphere.

11. The single-crystal production equipment according to any one of claims 2 to 10, wherein said hopper is constituted by plural hoppers in which granular raw materials having different compositions are each stored.

12. The single-crystal production equipment according to claim 1 , wherein said vessel heating equipment is a second infrared ray irradiation equipment.

13. The single-crystal production equipment according to claim 1, wherein said vessel heating equipment is a high-frequency induction heating equipment.

14. The single-crystal production equipment according to claim 1, wherein said vessel heating equipment is a resistance heating equipment.

15. The single-crystal production equipment according to claim 1, wherein said granular raw material melting vessel comprises a melting vessel rotating mechanism which rotates in the horizontal direction.

16. The single-crystal production equipment according to any one of claims 1 and 12 to 15 , wherein a part or the entirety of said granular raw material melting vessel is composed of platinum, iridium, quartz, silicon carbide, carbon, graphite, a carbon or graphite material whose surface has been converted to silicon carbide, or a carbon or graphite material whose surface has been coated with silicon carbide in advance.

17. The single-crystal production equipment according to any one of claims 1 to 16, comprising said granular raw material supply apparatus in a plural number.

18. The single-crystal production equipment according to claim 17, comprising said granular raw material melting apparatus in a plural number.

19. The single-crystal production equipment according to any one of claims 8 to 18, wherein a single-crystal holding table, on which said seed single crystal is placed, is arranged on the bottom of said single-crystal production chamber.

20. The single-crystal production equipment according to claim 19, wherein said single-crystal holding table comprises a holding table rotating mechanism which rotates in the horizontal direction.

21. The single-crystal production equipment according to claim 19 or 20, wherein said single-crystal holding table comprises an elevator apparatus which moves in the vertical direction at a prescribed speed.

22. The single-crystal production equipment according to any one of claims 1 to 21, wherein an auxiliary heating equipment is arranged on the outer side of said seed single crystal.

## Patentansprüche

1. Einkristallproduktionsgerät zum Herstellen eines großen Einkristalls durch Schmelzen eines Granulatrohstoffs unter Verwendung einer Granulatrohstoff-Schmelzvorrichtung, Zuführen der so erhaltenen Rohstoffschmelze in eine auf der oberen Oberfläche eines darunter befindlichen Saat-Einkristalls gebildete Schmelze, um eine gemischte Schmelze zu erzeugen, und dann Ausfällen eines Feststoffs als Einkristall aus der gemischten Schmelze,
wobei das Einkristallproduktionsgerät mindestens aufweist:
eine Granulatrohstoff-Zufuhrvorrichtung, die eine bestimmte Menge des Granulatrohstoffs nach unten zuführt;
die Granulatrohstoff-Schmelzvorrichtung, die den von der Granulatrohstoff-Zufuhrvorrichtung zugeführten Granulatrohstoff erhitzt und schmilzt und die so erhaltene Rohstoffschmelze nach unten zuführt; und
eine Kristallisationsvorrichtung, die einen Einkristall aus der gemischten Schmelze ausfällt, die sich beim Aufnehmen einer durch Bestrahlung der oberen Oberfläche des Saat-Einkristalls mit einem Infrarotstrahl von einem ersten Infrarotbestrahlungsgerät gebildeten Schmelze und der von der Granulatrohstoff-Schmelzvorrichtung zugeführten Rohstoffschmelze bildet,
wobei die Granulatrohstoff-Schmelzvorrichtung aufweist:
ein Granulatrohstoff-Schmelzgefäß, das den Granulatrohstoff (52) aufnimmt, und
ein Gefäßheizgerät, das das Granulatrohstoff-Schmelzgefäß erhitzt und dadurch das Granulatrohstoff-Schmelzgefäß schmilzt;
wobei das Granulatrohstoff-Schmelzgefäß aufweist:
einen Schmelzabschnitt, in dem der Granulatrohstoff (52) erhitzt und geschmolzen wird; und
einen Schmelze-haltenden Abschnitt, in dem nur eine in dem Schmelzabschnitt erzeugte Schmelze gehalten wird; und
wobei das Granulatrohstoff-Schmelzgefäß ausgewählt ist aus der Gruppe bestehend aus:
- einem bootförmigen Gefäß (61) und
einer Trennplatte (63), die das bootförmige Gefäß (61) in den Schmelzabschnitt und den Schmelze-haltenden Abschnitt teilt und eine Nut (66) an einem unteren Teil aufweist,
wobei die Rohstoffschmelze-Leitvorrichtung, die die aus dem Granulatrohstoff Schmelzgefäß abgelassene Rohstoffschmelze (67) auf die auf der oberen Oberfläche des darunter befindlichen Saat-Einkristalls (12) gebildete Schmelze zuführt, an einem unteren Ende des Granulatrohstoff-Schmelzgefäßes angeordnet ist, oder
- einer Schmelzschale (62) und
einer Trennschale (64), die innerhalb der Schmelzschale (62) angeordnet ist, einen Querschnitt in Form eines umgekehrten V aufweist und eine Nut an einem unteren Teil aufweist, und
das Granulatrohstoff-Schmelzgefäß derart eingerichtet ist, dass es zwischen der Schmelzschale (62) und der Trennschale (64) in den Schmelzabschnitt und den Schmelze-haltenden Abschnitt geteilt ist,
wobei die Rohstoffschmelze-Leitvorrichtung, die die aus dem Granulatrohstoff Schmelzgefäß abgelassene Rohstoffschmelze (67) auf die auf der oberen Oberfläche des darunter befindlichen Saat-Einkristalls (12) gebildete Schmelze zuführt, an einem unteren Ende des Granulatrohstoff-Schmelzgefäßes angeordnet ist oder
- wobei das Granulatrohstoff-Schmelzgefäß gebildet wird von:
einem zylindrischen Abschnitt (57) und
einem trichterförmigen Abschnitt (58), der innerhalb des zylindrischen Abschnitts (57) angeordnet ist und eine Öffnung an einem unteren Ende aufweist, und
die innere Seite des zylindrischen Abschnitts (57) den Schmelzabschnitt bildet und ein Raum zwischen der äußeren Seite des zylindrischen Abschnitts (57) und dem trichterförmigen Abschnitt (58) den Schmelze-haltenden Abschnitt bildet.

2. Einkristallproduktionsgerät nach Anspruch 1, wobei die Granulatrohstoff-Zufuhrvorrichtung aufweist:
einen Schüttgutbehälter, in dem der Granulatrohstoff gelagert ist; und
ein Gerät zur quantitativen Zufuhr von Granulatrohstoff, das den Granulatrohstoff in dem genannten Schüttgutbehälter derart steuert, dass er mit einer vorbestimmten Rate zugeführt wird, und eine bestimmte Menge des Granulatrohstoffes nach unten zuführt.

3. Einkristallproduktionsgerät nach Anspruch 1 oder 2, wobei die Granulatrohstoff-Zufuhrvorrichtung ein Granulatrohstoff-Schabegerät aufweist, das den Granulatrohstoff aus dem Schüttgutbehälter schabt und den Granulatrohstoff nach unten zuführt.

4. Einkristallproduktionsgerät nach Anspruch 2 oder 3, wobei die Granulatrohstoff-Zufuhrvorrichtung ein Zufuhrrohr aufweist, durch welches der Granulatrohstoff, der von dem Gerät zur quantitativen Zufuhr von Granulatrohstoff zugeführt wird, an eine vorbestimmte Position der Granulatrohstoff-Schmelzvorrichtung darunter zugeführt wird.

5. Einkristallproduktionsgerät nach Anspruch 4, wobei ein Material des Zufuhrrohrs Quarz ist.

6. Einkristallproduktionsgerät nach Anspruch 2, wobei der Schüttgutbehälter einen Befestigungs-/Abtrenn-Mechanismus zum Befestigen und Abtrennen eines Lagerbehälters aufweist, in dem der Granulatrohstoff gelagert ist.

7. Einkristallproduktionsgerät nach Anspruch 6, wobei der Befestigungs-/Abtrenn-Mechanismus eine Atmosphärenregelungsfunktion aufweist, die die Atmosphäre innerhalb des Befestigungs-/Abtrenn-Mechanismus und des Lagerbehälters willkürlich regelt.

8. Einkristallproduktionsgerät nach einem der Ansprüche 1 bis 7, wobei die Granulatrohstoff-Schmelzvorrichtung und die Kristallisationsvorrichtung innerhalb einer Einkristallproduktionskammer angeordnet sind.

9. Einkristallproduktionsgerät nach Anspruch 8, wobei die Granulatrohstoff Zufuhrvorrichtung innerhalb der Einkristallproduktionskammer angeordnet ist.

10. Einkristallproduktionsgerät nach Anspruch 8 oder 9, das ein Atmosphärenregelungsgerät aufweist, welches das Innere des Schüttgutbehälters mit der Einkristallproduktionskammer verbindet oder das Innere des Schüttgutbehälters und der Einkristallproduktionskammer derart regelt, dass sie die gleiche Atmosphäre aufweisen.

11. Einkristallproduktionsgerät nach einem der Ansprüche 2 bis 10, wobei der Schüttgutbehälter von mehreren Schüttgutbehältern gebildet wird, in denen jeweils Granulatrohstoffe mit unterschiedlichen Zusammensetzungen gelagert sind.

12. Einkristallproduktionsgerät nach Anspruch 1, wobei das Gefäßheizgerät ein zweites Infrarotbestrahlungsgerät ist.

13. Einkristallproduktionsgerät nach Anspruch 1, wobei das Gefäßheizgerät ein Hochfrequenz-Induktionsheizgerät ist.

14. Einkristallproduktionsgerät nach Anspruch 1, wobei das Gefäßheizgerät ein Widerstandsheizgerät ist.

15. Einkristallproduktionsgerät nach Anspruch 1, wobei das Granulatrohstoff-Schmelzgefäß einen Schmelzgefäß-Drehmechanismus aufweist, der sich in horizontaler Richtung dreht.

16. Einkristallproduktionsgerät nach einem der Ansprüche 1 und 12 bis 15, wobei ein Teil oder die Gesamtheit des Granulatrohstoff-Schmelzgefäßes aus Platin, Iridium, Quarz, Siliziumkarbid, Kohlenstoff, Graphit, einem Kohlenstoff- oder Graphitmaterial, dessen Oberfläche in Siliziumkarbid umgewandelt wurde, oder einem Kohlenstoff- oder Graphitmaterial, dessen Oberfläche im Voraus mit Siliziumkarbid beschichtet wurde, besteht.

17. Einkristallproduktionsgerät nach einem der Ansprüche 1 bis 16, das mehrere der Granulatrohstoff-Zufuhrvorrichtungen aufweist.

18. Einkristallproduktionsgerät nach Anspruch 17, das mehrere der Granulatrohstoff-Schmelzvorrichtungen aufweist.

19. Einkristallproduktionsgerät nach einem der Ansprüche 8 bis 18, wobei ein Einkristallhaltetisch, auf dem der Saat-Einkristall platziert wird, am Boden der Einkristallproduktionskammer angeordnet ist.

20. Einkristallproduktionsgerät nach Anspruch 19, wobei der Einkristallhaltetisch einen Haltetisch-Drehmechanismus aufweist, der sich in horizontaler Richtung dreht.

21. Einkristallproduktionsgerät nach Anspruch 19 oder 20, wobei der Einkristallhaltetisch eine Hebevorrichtung aufweist, die sich mit einer vorbestimmten Geschwindigkeit in vertikaler Richtung bewegt.

22. Einkristallproduktionsgerät nach einem der Ansprüche 1 bis 21, wobei ein Hilfsheizgerät an der Außenseite des Saat-Einkristalls angeordnet ist.

## Revendications

1. Un équipement de production de monocristal destiné à produire un monocristal de grande taille en faisant fondre une matière première granulaire à l'aide d'un appareil de fusion de matière première granulaire, en fournissant la matière première fondue ainsi obtenue sous forme de masse fondue formée sur la surface supérieure d'un germe de monocristal en bas pour générer un mélange fondu, et en laissant ensuite un solide précipiter à partir dudit mélange fondu sous la forme d'un monocristal,
dans lequel ledit équipement de production de monocristal comprend, au moins:
un appareil d'alimentation en matière première granulaire qui fournit une certaine quantité de ladite matière première granulaire vers le bas;
ledit appareil de fusion de matière première granulaire qui chauffe et fait fondre ladite matière première granulaire fournie par ledit appareil d'alimentation en matière première granulaire et fournit la matière première fondue ainsi obtenue vers le bas; et
un appareil de cristallisation qui permet à un monocristal de précipiter à partir dudit mélange fondu qui est formé à la réception d'une masse fondue formée lors de l'irradiation par rayons infrarouges provenant d'un premier équipement d'irradiation par rayons infrarouges sur la surface supérieure dudit germe de monocristal et de ladite matière première fondue fournie par ledit appareil de fusion de matière première granulaire.
dans lequel ledit appareil de fusion de matière première granulaire comprend:
un récipient de fusion de matière première granulaire qui reçoit ladite matière première granulaire (52), et
un équipement de chauffage de récipient qui chauffe ledit récipient de fusion de matière première granulaire et fait ainsi fondre ledit récipient de fusion de matière première granulaire;
dans lequel ledit récipient de fusion de matière première granulaire comprend:
une section de fusion dans laquelle ladite matière première granulaire (52) est chauffée et fondue; et
une section de retenue de masse fondue dans laquelle seule une masse fondue générée dans ladite section de fusion est retenue; et
dans lequel ledit récipient de fusion de matière première granulaire est choisi parmi le groupe constitué par:
- un récipient en forme de bateau (61), et
une plaque de séparation (63) qui divise ledit récipient en forme de bateau (61)) en ladite section de fusion et ladite section de retenue de masse fondue et comprend une rainure (66) sur une partie inférieure,
dans lequel l'appareil de guidage de matière première fondue, qui fournit ladite matière première fondue (67) déchargée dudit récipient de fusion de matière première granulaire sur ladite masse fondue formée sur la surface supérieure dudit germe de monocristal (12) ci-dessous, est disposé à une extrémité inférieure dudit récipient de fusion de matière première granulaire, ou
- une cuvette de fusion (62), et
une cuvette de séparation (64) qui est disposée à l'intérieur de ladite cuvette de fusion (62), comporte une section transversale en forme de V inversé et comprend une rainure sur une partie inférieure, et
ledit récipient de fusion de matière première granulaire est configuré de manière à être divisé en ladite section de fusion et ladite section de retenue de masse fondue entre ladite cuvette de fusion (62) et ladite cuvette de séparation (64),
dans lequel l'appareil de guidage de matière première fondue, qui fournit ladite matière première (67) fondue déchargée dudit récipient de fusion de matière première granulaire sur ladite masse fondue formée sur la surface supérieure dudit germe de monocristal (12) ci-dessous, est disposé à une extrémité inférieure dudit récipient de fusion de matière première granulaire, ou
- dans lequel ledit récipient de fusion de matière première granulaire est constitué par:
une section cylindrique (57), et
une section en forme d'entonnoir (58) qui est disposée à l'intérieur de ladite section cylindrique (57) et présente une ouverture à une extrémité inférieure, et
le côté intérieur de ladite section cylindrique (57) constitue ladite section de fusion et un espace entre le côté extérieur de ladite section cylindrique (57) et ladite section en forme d'entonnoir (58) constitue ladite section de retenue de masse fondue.

2. L'équipement de production de monocristal selon la revendication 1, dans lequel ledit appareil d'alimentation en matière première granulaire comprend:
une trémie qui stocke ladite matière première granulaire; et
un équipement d'alimentation quantitative en matière première granulaire qui contrôle ladite matière première granulaire dans ladite trémie pour qu'elle soit fournie à un débit prescrit et fournit une certaine quantité de ladite matière première granulaire vers le bas.

3. L'équipement de production de monocristal selon la revendication 1 ou 2, dans lequel ledit appareil d'alimentation en matière première granulaire comprend un équipement de raclage de matière première granulaire qui racle ladite matière première granulaire hors de ladite trémie et fournit ladite matière première granulaire vers le bas.

4. L'équipement de production de monocristal selon la revendication 2 ou 3, dans lequel ledit appareil d'alimentation en matière première granulaire comprend un tuyau d'alimentation à travers lequel ladite matière première granulaire fournie par ledit équipement d'alimentation quantitative en matière première granulaire est fournie à une position prescrite dudit appareil de fusion de matière premières granulaire en bas.

5. L'équipement de production de monocristal selon la revendication 4, dans lequel un matériau dudit tuyau d'alimentation est le quartz.

6. L'équipement de production de monocristal selon la revendication 2, dans lequel ladite trémie comprend un mécanisme de fixation-détachement pour fixer et détacher un réservoir de stockage stockant ladite matière première granulaire.

7. L'équipement de production de monocristal selon la revendication 6, dans lequel ledit mécanisme de fixation-détachement a une fonction de contrôle de l'atmosphère permettant de contrôler arbitrairement l'atmosphère à l'intérieur dudit mécanisme de fixation-détachement et dudit réservoir de stockage.

8. L'équipement de production de monocristal selon l'une quelconque des revendications 1 à 7, dans lequel ledit appareil de fusion de matière première granulaire et ledit appareil de cristallisation sont disposés à l'intérieur d'une chambre de production de monocristal.

9. L'équipement de production de monocristal selon la revendication 8, dans lequel ledit appareil d'alimentation en matière première granulaire est disposé à l'intérieur de ladite chambre de production de monocristal.

10. L'équipement de production de monocristal selon la revendication 8 ou 9, comprenant un équipement de contrôle d'atmosphère qui relie l'intérieur de ladite trémie à ladite chambre de production de monocristal, ou contrôle l'intérieur de ladite trémie et de ladite chambre de production de monocristal pour avoir la même atmosphère.

11. L'équipement de production de monocristal selon l'une quelconque des revendications 2 à 10, dans lequel ladite trémie est constituée de plusieurs trémies dans lesquelles sont stockées chacune des matières premières granulaires ayant des compositions différentes.

12. L'équipement de production de monocristal selon la revendication 1, dans lequel ledit équipement de chauffage de récipient est un deuxième équipement d'irradiation par rayons infrarouges.

13. L'équipement de production de monocristal selon la revendication 1, dans lequel ledit équipement de chauffage de récipient est un équipement de chauffage par induction à haute fréquence.

14. L'équipement de production de monocristal selon la revendication 1, dans lequel ledit équipement de chauffage de récipient est un équipement de chauffage à résistance.

15. L'équipement de production de monocristal selon la revendication 1, dans lequel ledit récipient de fusion de matière première granulaire comprend un mécanisme de rotation de récipient de fusion qui tourne dans la direction horizontale.

16. L'équipement de production de monocristal selon l'une quelconque des revendications 1 et 12 à 15, dans lequel une partie ou la totalité dudit récipient de fusion de matière première granulaire est composée de platine, d'iridium, de quartz, de carbure de silicium, de carbone, de graphite, d'un matériau de carbone ou de graphite dont la surface a été transformée en carbure de silicium, ou d'un matériau de carbone ou de graphite dont la surface a été préalablement recouverte de carbure de silicium.

17. L'équipement de production de monocristal selon l'une quelconque des revendications 1 à 16, comprenant ledit appareil d'alimentation en matière première granulaire au pluriel.

18. L'équipement de production de monocristal selon la revendication 17, comprenant ledit appareil de fusion de matière première granulaire au pluriel.

19. L'équipement de production de monocristal selon l'une quelconque des revendications 8 à 18, dans lequel une table de maintien de monocristal, sur laquelle ledit germe de monocristal est placé, est disposée au fond de ladite chambre de production de monocristal.

20. L'équipement de production de monocristal selon la revendication 19, dans lequel ladite table de maintien de monocristal comprend un mécanisme de rotation de table de maintien qui tourne dans la direction horizontale.

21. L'équipement de production de monocristal selon la revendication 19 ou 20, dans lequel ladite table de maintien de monocristal comprend un appareil élévateur qui se déplace dans la direction verticale à une vitesse prescrite.

22. L'équipement de production de monocristal selon l'une quelconque des revendications 1 à 21, dans lequel un équipement de chauffage auxiliaire est disposé sur le côté extérieur dudit germe de monocristal.
